# EUROPÄISCHE PATENTSCHRIFT

(11) **EP 1 333 579 B1**
(45) Veröffentlichungstag und Bekanntmachung des Hinweises auf die Patenterteilung: **13.03.2013**
(21) Anmeldenummer: 02002305.7
(22) Anmeldetag: 30.01.2002
(51) Int. Cl.: H03K 5/19, G06F 1/04

(54) **Einrichtung zur Erkennung eines Taktsignalausfalls**
Device for recognising clock failure
Dispositif pour la détection d'une erreur d'horloge

(43) Veröffentlichungstag der Anmeldung: 06.08.2003
(73) Patentinhaber: Infineon Technologies AG, 85579 Neubiberg (DE)
(72) Erfinder: von Wendorff, Wilhard Christophorus, Dr., 81241 München (DE)
(74) Vertreter: Repkow, Ines

(56) Entgegenhaltungen:
- WO-A-90/04287
- US-A- 6 069 498
- US-B1- 6 333 646
- PATENT ABSTRACTS OF JAPAN vol. 017, no. 137 (E-1335), 22. März 1993 (1993-03-22) -& JP 04 306930 A (SEIKO EPSON CORP), 29. Oktober 1992 (1992-10-29)
- PATENT ABSTRACTS OF JAPAN vol. 014, no. 125 (E-0900), 8. März 1990 (1990-03-08) -& JP 01 319325 A (HITACHI COMMUN SYST INC), 25. Dezember 1989 (1989-12-25)
- PATENT ABSTRACTS OF JAPAN vol. 011, no. 219 (P-596), 16. Juli 1987 (1987-07-16) -& JP 62 035930 A (FUJITSU LTD), 16. Februar 1987 (1987-02-16)
- SKINNER J: "Digital frequency window", ELECTRONICS AND TELEVISION AND SHORTWAVE WORLD, HULTON PRESS LTD. LONDON, GB, vol. 60, no. 739, 1 July 1988 (1988-07-01) , page 27, XP002147205,

## Beschreibung

Die vorliegende Erfindung betrifft eine Vorrichtung gemäß dem Oberbegriff des Patentanspruchs 1.

Taktsignale werden in synchron arbeitenden digitalen Schaltungen benötigt, und durch einen innerhalb oder außerhalb der betreffenden Schaltung vorgesehenen Taktsignalgenerator erzeugt.

Der Ausfall des Taktsignals hat im allgemeinen den Ausfall der gesamten Schaltung, unter Umständen sogar des die betreffende Schaltung enthaltenden Systems zur Folge, was insbesondere bei Anwendungen, von welchen die Sicherheit von Personen, Tieren oder Gegenständen abhängt, unter allen Umständen vermieden werden muß, oder zumindest sofort erkannt werden muß.

Zu diesen Anwendungen gehört beispielsweise die Steuerung des Airbags oder des Anti-Blockiersystems eines Kraftfahrzeuges.

Im folgenden wird davon ausgegangen, daß die abhängig von einem Taktsignal arbeitende Schaltung ein Mikrocontroller ist. In diesem Fall wird der das Taktsignal erzeugende Taktsignalgenerator im allgemeinen durch eine innerhalb des Mikrocontrollers vorgesehene PLL, und einen außerhalb des Mikrocontrollers vorgesehenen Quartz-Oszillator ein gebildet.

In diesem Fall könnte ein Ausfall des Taktsignals durch eine der beiden folgenden Möglichkeiten ermittelt werden:
Die erste Möglichkeit besteht darin, daß zwei Taktsignalgeneratoren vorgesehen werden, genauer gesagt zwei PLLs und zwei Quartz-Oszillatoren, und daß die von diesen Taktsignalgeneratoren erzeugten Taktsignale daraufhin überprüft werden, ob die übereinstimmen oder in einer bestimmten Beziehung zueinander stehen. Dadurch kann zuverlässig erkannt werden, ob eines der Taktsignale ausgefallen ist. Allerdings erfordert insbesondere das Vorsehen von zwei Taktsignalgeneratoren einen erheblichen zusätzlichen Aufwand. Darüber hinaus steigen dadurch auch der Stromverbrauch und die Erwärmung des Mikrocontrollers stark an.

Die zweite Möglichkeit besteht in der Durchführung eines Plausibilitäts-Checks der sich in der PLL einstellenden Verhältnisse. Da die sich in der PLL einstellenden Verhältnisse jedoch stark von der Temperatur und der verwendeten Herstellungstechnologie abhängen, und selbst bei konstanter Temperatur und gleicher Herstellungstechnologie starken Schwankungen unterworfen sind, ist es nur mit großem Aufwand, und teilweise sogar überhaupt nicht möglich, zuverlässig einen Ausfall des Taktsignals zu erkennen.

Weitere Einrichtungen zur Erkennung eines Taktsignalausfalls sind aus
- Patent Abstracts of Japan, Bd. 017, Nr. 137 (E-1335), 22. März 1993 (1993-03-22) & JP 04-306930 A (Seiko Epson Corp), 29. Oktober 1992 (1992-10-29) und aus
- Skinner J: "Digital frequency window", Electronics and Television and Shortwave World, Hulton Press Ltd. London, GB, Bd. 60, Nr. 739, 1. Juli 1988 (1988-07-01), Seite 27, XP002147205
bekannt. Die im letztgenannten Dokument beschriebene Einrichtung ist eine Einrichtung gemäß dem Oberbegriff des Patentanspruchs 1. Die bekannten Einrichtungen weisen jedoch ebenfalls die vorstehend angesprochenen Probleme auf oder bieten zumindest keine zufriedenstellende Lösung für diese.

Der vorliegenden Erfindung liegt daher die Aufgabe zugrunde, eine Einrichtung zur Erkennung eines Taktsignalausfalls zu schaffen, die einfach realisierbar ist und zuverlässig arbeitet.

Diese Aufgabe wird erfindungsgemäß durch die in Patentanspruch 1 beanspruchte Einrichtung gelöst.

Eine solche Einrichtung zur Erkennung eines Taktausfalls läßt sich erkennbar einfach realisieren. Sie arbeitet darüber hinaus auch sehr zuverlässig, weil die Ereignisse, durch welche die Zählperiode des Zählers festgelegt wird, synchrone Ereignisse sind, deren Auftreten keinen oder nur sehr geringen Schwankungen unterworfen ist, und weil durch das Vorsehen des zweiten Zählers verhindert werden kann, daß schon unbedeutende Schwankungen der Frequenz des Taktsignals, oder Schwankungen des zeitlichen Abstandes der Ereignisse, durch welche die Zählperiode des Zählers festgelegt wird, zu Fehlermeldungen führen.

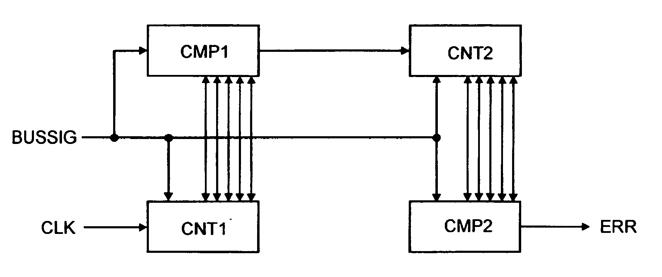

Vorteilhafte Weiterbildungen der Erfindung sind den Unteransprüchen, der folgenden Beschreibung, und der Figur entnehmbar.

Die Erfindung wird nachfolgend anhand eines Ausführungsbeispiels unter Bezugnahme auf die Figur näher erläutert.

Die Figur zeigt ein Ausführungsbeispiel der im folgenden beschriebenen Einrichtung zur Erkennung eines Taktsignalausfalls.

Die im folgenden beschriebene Einrichtung zur Erkennung eines Taktsignalausfalls ist Bestandteil einer programmgesteuerten Einheit wie beispielsweise eines Mikrocontrollers, Mikroprozessors, eines Signalprozessors oder dergleichen. Es sei jedoch bereits an dieser Stelle darauf hingewiesen, daß die beschriebene Einrichtung auch Bestandteil einer beliebigen anderen synchron arbeitenden digitalen Schaltung sein kann.

Der Mikrocontroller, der die beschriebene Einrichtung zur Erkennung eines Taktsignalausfalls enthält, ist über eine oder mehrere Verbindungsleitungen mit wenigsten einem anderen Baustein verbunden, und bekommt über die mindestens eine Verbindungsleitung von dem mindestens einen anderen Baustein in regelmäßigen oder unregelmäßigen zeitlichen Abständen weiterzuverarbeitende Daten und eventuell zusätzlich die Datenübertragung betreffende Steuerinformationen (Übertragungstaktsignale, Handshake-Signale etc.) zugeführt.

Bei der mindestens einen Verbindungsleitung kann es sich um einen externen Bus oder um einen Teil eines externen Busses handeln, über welchen die Komponenten des den Mikrocontroller enthaltenden Systems miteinander verbunden sind und Daten austauschen. Dieser Bus kann beispielsweise ein CAN-Bus, ein Byteflight-Bus, ein Flexray-Bus, oder ein beliebiger anderer Bus sein.

Wie im folgenden noch genauer beschrieben wird, arbeitet die beschriebene Einrichtung zur Erkennung eines Taktsignalausfalls abhängig von bestimmten Ereignissen, die auf der mindestens einen Verbindungsleitung auftreten.

Der prinzipielle Aufbau der vorliegend betrachteten Einrichtung zur Erkennung eines Taktsignalausfalls ist in der Figur dargestellt.

Wie aus der Figur ersichtlich ist, besteht die darin gezeigte Einrichtung aus einem ersten Zähler CNT1, einer ersten Vergleichseinrichtung CMP1, einem zweiten Zähler CNT2, und einer zweiten Vergleichseinrichtung CMP2. Die Einrichtung erhält als Eingangssignale das Taktsignal CLK, dessen Vorhandensein durch sie überprüft werden soll, sowie zumindest einen Teil der über die mindestens eine Verbindungsleitung übertragenen Signale BUSSIG. Als Ausgangssignal erzeugt die Einrichtung ein Fehlersignal ERR, durch welches signalisiert wird, ob das Taktsignal CLK vorhanden ist, und ob es die ordnungsgemäße Frequenz aufweist.

Der erste Zähler CNT1
- zählt die Takte des Taktsignals CLK,
- wird durch das Auftreten eines bestimmten Ereignisses, beispielsweise beim Auftreten einer steigenden Flanke oder einer fallenden Flanke in den Signalen BUSSIG zurückgesetzt, und
- gibt seinen Zählstand an die erste Vergleichseinrichtung CMP1 aus.

Die erste Vergleichseinrichtung CMP1
- erhält den jeweils aktuellen Zählstand des ersten Zählers CNT1 zugeführt,
- wird durch das Ereignis, durch welches der erste Zähler CNT1 zurückgesetzt wird, getriggert,
- vergleicht im Ansprechen auf die Triggerung desselben den aktuellen Zählstand des ersten Zählers CNT1 mit einem in ihm gespeicherten ersten Referenzwert, und
- gibt das Ergebnis des Vergleichs aus.

Der erste Referenzwert, mit welchem die erste Vergleichseinrichtung CMP1 den Zählstand des ersten Zählers CNT1 vergleicht, ist ein Wert, den der Zählstand des ersten Zählers CNT1 nicht unterschreitet, wenn das Taktsignal CLK vorhanden ist, und eine ordnungsgemäß hohe Frequenz aufweist.

Somit könnte bereits das Ergebnis des von der ersten Vergleichseinrichtung durchgeführten Vergleichs als Fehlersignal ERR verwendet werden: ergibt der Vergleich, daß der Zählstand des ersten Zählers CNT1 größer als oder gleich groß wie der erste Referenzwert ist, kann davon ausgegangen werden, daß das Taktsignal CLK vorhanden ist, und eine ordnungsgemäß hohe Frequenz aufweist; ergibt der Vergleich, daß der Zählstand des ersten Zählers CNT1 kleiner ist als der erste Referenzwert, kann davon ausgegangen werden, daß das Taktsignal CLK ausgefallen ist oder eine zu niedrige Frequenz aufweist.

In Anbetracht der Tatsache, daß die Frequenz des Taktsignals CLK und/oder das Auftreten der die Zählperiode bestimmenden Ereignisse kleineren Schwankungen unterworfen sein können, wird das Ausgangssignal der ersten Vergleichseinrichtung im betrachteten Beispiel nicht als Fehlersignal ERR verwendet, sondern durch den zweiten Zähler CNT2 und die zweite Vergleichseinrichtung weiterverarbeitet.

Das Vergleichsergebnis der ersten Vergleichseinrichtung CMP1 wird dem zweiten Zähler CNT2 zugeführt.

Unter bestimmten Umständen kann auf das Vorsehen der ersten Vergleichseinrichtung CMP1 verzichtet werden. Dies ist beispielsweise der Fall, wenn an einem bestimmten Bit des Zählstandes des ersten Zählers CNT1 erkennbar ist, ob der Zählstand größer oder kleiner als der erste Referenzwert ist. In diesem Fall könnte dieses eine Bit anstelle des Ausgangssignals der ersten Vergleichseinrichtung CMP1 dem zweiten Zähler CNT2 zugeführt werden.

Der zweite Zähler CNT2
- bekommt von der ersten Vergleichseinrichtung CMP1 das Vergleichsergebnis zugeführt und legt abhängig vom Vergleichsergebnis fest, ob ein Aufwärtszählen oder ein Abwärtszählen erfolgen soll,
- zählt die Ereignisse, durch welche der erste Zähler CNT1 zurückgesetzt und die erste Vergleichseinrichtung CMP1 getriggert wird, wobei eine Erhöhung des Zählstandes erfolgt, wenn durch das dem zweiten Zähler CNT2 zugeführte Vergleichsergebnis angezeigt wird, daß der Zählstand des ersten Zählers CNT1 kleiner war als der erste Referenzwert, und wobei eine Verringerung des Zählstandes erfolgt, wenn durch das dem zweiten Zähler CNT2 zugeführte Vergleichsergebnis angezeigt wird, daß der Zählstand des ersten Zählers CNT1 nicht kleiner war als der erste Referenzwert, und
- gibt den Zählstand an die zweite Vergleichseinrichtung CMP2 aus.

Die zweite Vergleichseinrichtung CMP2
- erhält den jeweils aktuellen Zählstand des zweiten Zählers CNT2 zugeführt,
- wird durch das Ereignis, durch welches der erste Zähler CNT1 zurückgesetzt wird, und die erste Vergleichseinrichtung CMP1 und der zweite Zähler CNT2 getriggert werden, getriggert,
- vergleicht im Ansprechen auf die Triggerung desselben den aktuellen Zählstand des zweiten Zählers CNT2 mit einem in ihm gespeicherten zweiten Referenzwert, und
- gibt das Ergebnis des Vergleichs aus.

Wie vorstehend bereits angedeutet wurde, wird das Ausgangssignal der zweiten Vergleichseinrichtung CMP2 als Fehlersignal ERR verwendet.

Durch den zweiten Zähler CNT2 und die zweite Vergleichseinrichtung CMP2 wird erreicht, daß erst dann ein Fehler signalisiert wird, wenn mehrfach festgestellt wurde, daß das Taktsignal CLK nicht vorhanden ist oder eine zu niedrige Frequenz aufweist. Dadurch kann verhindert werden, daß schon unbedeutende Schwankungen der Frequenz des Taktsignals, oder Schwankungen des zeitlichen Abstandes der Ereignisse, durch deren Auftreten die Komponenten der in der Figur gezeigten Anordnung zurückgesetzt bzw. getriggert werden, zu Fehlermeldungen führen.

Unter bestimmten Umständen kann auf das Vorsehen der zweiten Vergleichseinrichtung CMP2 verzichtet werden. Dies ist beispielsweise der Fall, wenn an einem bestimmten Bit des Zählstandes des zweiten Zählers CNT2 erkennbar ist, ob der Zählstand größer oder kleiner als der zweite Referenzwert ist. In diesem Fall könnte dieses eine Bit anstelle des Ausgangssignals der zweiten Vergleichseinrichtung CMP2 als Fehlersignal ERR verwendet werden.

Durch eine wie vorstehend beschrieben betriebene Einrichtung wird ein Fehler signalisiert, wenn davon ausgegangen werden kann, daß das Taktsignal ausgefallen ist oder eine zu niedrige Frequenz aufweist.

Durch geringfügige Modifikationen kann die beschriebene Einrichtung auch dazu verwendet werden, einen Fehler zu signalisieren, wenn die Frequenz des Taktsignals CLK zu hoch ist. Dies ist beispielsweise dadurch möglich, daß dafür gesorgt wird, daß der zweite Zähler CNT2 aufwärts zählt, wenn der Zählstand des ersten Zählers CNT1 größer ist als der erste Referenzwert, und daß der zweite Zähler CNT2 abwärts zählt, wenn der Zählstand des ersten Zählers CNT1 kleiner ist als der erste Referenzwert.

Dies setzt jedoch voraus,
- daß die über die mindestens eine Verbindungsleitung übertragenen Signale in konstanten zeitlichen Abständen ihren Pegel wechseln, oder
- daß durch einen der Einrichtung vorgeschalteten Filter dafür gesorgt wird, daß nur solche Ereignisse zum Rücksetzen bzw. Triggern der Komponenten der in der Figur gezeigten Einrichtung verwendet werden, durch die ein Zeitraum bestimmter Länge definiert wird.

Unabhängig hiervon kann es sich als vorteilhaft erweisen, wenn die über die mindestens eine Verbindungsleitung übertragenen Signale vor deren Zuführung an die betrachtete Einrichtung einer Tiefpaßfilterung unterzogen werden. Dadurch kann verhindert werden, daß die Fehlererkennung durch hochfrequente Störsignale gestört wird.

Noch sicherer funktioniert die Fehlererkennung, wenn
- die Signale, die zum Rücksetzen bzw. Triggern der Komponenten der betrachteten Einrichtung verwendet werden, in komplementärer Form auf zwei Verbindungsleitungen übertragen werden,
- diese Verbindungsleitungen zu Zeiten, während welcher nicht durch einen Treiber Signale auf sie ausgegeben werden, durch einen Pull-Up-Widerstand oder einen Pull-Down-Widerstand auf einen bestimmten Pegel gezogen werden, wobei dieser Pegel für beide Verbindungsleitungen der selbe Pegel ist,
- die Treiber nur dann aktiv werden, wenn ein Signal zu übertragen ist, dessen Pegel sich von dem Pegel, auf welchen die betreffende Verbindungsleitung durch den Pull-Up-Widerstand oder den Pull-Down-Widerstand gebracht wird, unterscheidet, und
- die Einrichtung zur Erkennung eines Taktausfalls durch ein Signal angesteuert wird, das aus einer logischen Verknüpfung (beispielsweise aus einer EXOR-Verknüpfung) der über die beiden Verbindungsleitungen übertragenen Signale resultiert, oder zwei Einrichtungen zur Erkennung eines Taktsignalausfalls vorgesehen werden, von welchen die eine durch die auf der einen Verbindungsleitung übertragenen Signale gesteuert wird, und von welchen die andere durch die auf der anderen Verbindungsleitung übertragenen Signale gesteuert wird.

Dadurch kann erreicht werden, daß ein Ausfall des Taktsignals auch dann erkannt werden kann, wenn ein Treiber des die beschriebene Einrichtung enthaltenden Bausteins aufgrund des Ausfalls des Taktsignals dauerhaft im aktiven Zustand bleibt. Dies wäre nicht möglich, wenn die zu übertragenden Signale nur über eine Verbindungsleitung übertragen werden würden. In diesem Fall hätte ein im aktiven Zustand blockierter Treiber zur Folge, daß auf der Verbindungsleitung keine Pegelwechsel mehr auftreten, und demzufolge auch keine ordnungsgemäße Ansteuerung der Einrichtung zur Erkennung eines Taktsignalausfalls möglich wäre.

Die beschriebene Einrichtung zur Erkennung eines Taktsignalausfalls ermöglicht unabhängig von den Einzelheiten der praktischen Realisierung, daß der Ausfall eines Taktsignals oder ein nicht ordnungsgemäßer Taktsignalverlauf mit geringem Aufwand zuverlässig erkannt werden kann.

### Bezugszeichenliste

- BUSSIG: externes Signal zur Steuerung der Einrichtung zur Erkennung eines Taktsignalausfalls
- CLK: Taktsignal
- CNT1: erster Zähler
- CNT2: zweiter Zähler
- CMP1: erster Vergleicher
- CMP2: zweiter Vergleicher
- ERR: Fehlersignal

## Patentansprüche

1. Einrichtung zur Erkennung eines Taktsignalausfalls,
- wobei die Einrichtung einen Zähler (CNT1) enthält, welcher dazu eingerichtet ist, die zwischen zwei bestimmten Ereignissen auftretende Anzahl der Takte des Taktsignals (CLK) zu zählen, dessen Vorhandensein zu überprüfen ist, und
- wobei die Einrichtung dazu eingerichtet ist, das Auftreten eines Fehlers zu signalisieren, wenn der Zählstand des Zählers (CNT1) einmal oder öfters einen bestimmten Referenzwert unterschreitet, oder wenn der Zählstand des Zählers (CNT1) einmal oder öfters einen bestimmten Referenzwert überschreitet,
**dadurch gekennzeichnet,**
- **daß** die bestimmten Ereignisse, zwischen welchen der Zähler (CNT1) die Anzahl der Takte des Taktsignals (CLK) zählt, Ereignisse sind, die auf einer oder mehreren Verbindungsleitungen auftreten, über welche der die Einrichtung enthaltende Baustein mit einem oder mehreren anderen Bausteinen verbunden ist, und über welche dem die Einrichtung enthaltenden Baustein von dem anderen Baustein bzw. von den anderen Bausteinen Signale (BUSSIG) zugeführt werden,
- **daß** die bestimmten Ereignisse, zwischen welchen der Zähler (CNT1) die Anzahl der Takte des Taktsignals (CLK) zählt, synchrone Ereignisse sind, deren Auftreten keinen oder nur sehr geringen Schwankungen unterworfen ist, und
- **daß** die Einrichtung einen zweiten Zähler (CNT2) enthält, der so eingerichtet ist,
- **daß** sein Zählstand inkrementiert wird, wenn der Zählstand des ersten Zählers (CNT1) kleiner ist als der Referenzwert, und dekrementiert wird, wenn der Zählstand des ersten Zählers (CNT1) nicht kleiner ist als der Referenzwert, oder der so eingerichtet ist,
- **daß** sein Zählstand dekrementiert wird, wenn der Zählstand des ersten Zählers (CNT1) kleiner ist als der Referenzwert, und inkrementiert wird, wenn der Zählstand des ersten Zählers (CNT1) nicht kleiner ist als der Referenzwert.

2. Einrichtung nach Anspruch 1,
**dadurch gekennzeichnet,**
**daß** die Einrichtung so eingerichtet ist, daß sie den Ausfall des Taktsignals (CLK) signalisiert, wenn das Taktsignal (CLK) ausgefallen ist oder eine zu niedrige Frequenz aufweist.

3. Einrichtung nach Anspruch 1,
**dadurch gekennzeichnet,**
**daß** die Einrichtung so eingerichtet ist, daß sie den Ausfall des Taktsignals (CLK) signalisiert, wenn das Taktsignal (CLK) eine zu hohe Frequenz aufweist.

4. Einrichtung nach einem der vorhergehenden Ansprüche,
**dadurch gekennzeichnet,**
**daß** die Signale (BUSSIG), die dem die Einrichtung enthaltenden Baustein zugeführt werden, Daten sind, die der betreffende Baustein weiterverarbeitet.

5. Einrichtung nach einem der vorhergehenden Ansprüche,
**dadurch gekennzeichnet,**
**daß** die Signale (BUSSIG), die dem die Einrichtung enthaltenden Baustein zugeführt werden, Steuersignale sind, welche zur Übertragung von Daten an den die Einrichtung enthaltenden Baustein benötigt werden.

6. Einrichtung nach einem der vorhergehenden Ansprüche,
**dadurch gekennzeichnet,**
**daß** die mindestens eine Verbindungsleitung eine Leitung zum Austausch von Daten zwischen den durch die mindestens eine Verbindungsleitung miteinander verbundenen Bausteinen ist.

7. Einrichtung nach einem der vorhergehenden Ansprüche,
**dadurch gekennzeichnet,**
**daß** die mindestens eine Verbindungsleitung ein Bus oder Teil eines Busses ist.

8. Einrichtung nach einem der vorhergehenden Ansprüche,
**dadurch gekennzeichnet,**
**daß** die bestimmten Ereignisse, zwischen welchen der Zähler (CNT1) die Anzahl der Takte des Taktsignals (CLK) zählt, steigende oder fallende Flanken der über die mindestens eine Verbindungsleitung übertragenen Signale sind.

9. Einrichtung nach einem der vorhergehenden Ansprüche,
**dadurch gekennzeichnet,**
**daß** die bestimmten Ereignisse, zwischen welchen der Zähler (CNT1) die Anzahl der Takte des Taktsignals (CLK) zählt, Ereignisse sind, durch welche ein Zeitraum mit einer bestimmten Länge definiert wird.

10. Einrichtung nach einem der vorhergehenden Ansprüche, **dadurch gekennzeichnet,**
**daß** die Einrichtung einen Vergleicher (CMP1) enthält, und daß
der Vergleicher (CMP1) dazu eingerichtet ist zu überprüfen, ob der Zählstand des Zählers (CNT1) den Referenzwert überschreitet oder unterschreitet.

11. Einrichtung nach einem der vorhergehenden Ansprüche,
**dadurch gekennzeichnet, daß** die Einrichtung so eingerichtet ist,
**daß** es vom Vergleichsergebnis des Vergleichers (CMP1) abhängt, ob der zweite Zähler (CNT2) aufwärts oder abwärts zählt.

12. Einrichtung nach einem der Ansprüche 1 bis 10,
**dadurch gekennzeichnet, daß** die Einrichtung so eingerichtet ist,
**daß** es vom Wert eines bestimmten Bits des Zählstandes des ersten Zählers (CNT1) abhängt, ob der zweite Zähler (CNT2) aufwärts oder abwärts zählt.

13. Einrichtung nach einem der vorhergehenden Ansprüche,
**dadurch gekennzeichnet,**
**daß** die Einrichtung einen zweiten Vergleicher (CMP2) enthält, und daß der zweite Vergleicher (CMP2) dazu eingerichtet ist zu überprüfen, ob der Zählstand des zweiten Zählers (CNT2) einen zweiten Referenzwert überschreitet oder unterschreitet.

14. Einrichtung nach Anspruch 13,
**dadurch gekennzeichnet,**
**daß** das Ausgangssignal des zweiten Vergleichers als ein Fehlersignal (ERR) verwendet wird, durch welches signalisiert wird, ob ein Taktsignalausfall vorliegt oder nicht.

15. Einrichtung nach einem der vorhergehenden Ansprüche,
**dadurch gekennzeichnet,**
**daß** ein bestimmtes Bit des Zählstandes des zweiten Zählers (CNT2) als ein Fehlersignal (ERR) verwendet wird, durch welches signalisiert wird, ob ein Taktsignalausfall vorliegt oder nicht.

16. Einrichtung nach Anspruch 10,
**dadurch gekennzeichnet,**
**daß** das Ausgangssignal des ersten Vergleichers (CMP1) als ein Fehlersignal (ERR) verwendet wird, durch welches signalisiert wird, ob ein Taktsignalausfall vorliegt oder nicht.

17. Einrichtung nach Anspruch 1,
**dadurch gekennzeichnet,**
**daß** ein bestimmtes Bit des Zählstandes des ersten Zählers (CNT1) als ein Fehlersignal (ERR) verwendet wird, durch welches signalisiert wird, ob das Taktsignal (CLK) einen ordnungsgemäßen Verlauf hat oder nicht.

## Claims

1. Device for recognizing a clock signal failure,
- wherein the device contains a counter (CNT1) which is set up to count the number of clock cycles of the clock signal (CLK) that is to have its presence checked which occur between two particular events, and
- wherein the device is set up to signal the occurrence of an error if the count on the counter (CNT1) is below a particular reference value once or more often or if the count on the counter (CNT1) is above a particular reference value once or more often,
**characterized**
- **in that** the particular events between which the counter (CNT1) counts the number of clock cycles of the clock signal (CLK) are events which occur on one or more connecting lines by means of which the chip containing the device is connected to one or more other chips and by means of which the chip containing the device is supplied with signals (BUSSIG) by the other chip or by the other chips,
- **in that** the particular events between which the counter (CNT1) counts the number of clock cycles of the clock signal (CLK) are synchronous events, the occurrence of which is subject to no or only very small fluctuations, and
- **in that** the device contains a second counter (CNT2) which is set up such
- that the count thereon is incremented if the count on the first counter (CNT1) is lower than the reference value, and is decremented if the count on the first counter (CNT1) is not lower than the reference value, or which is set up such
- that the count thereon is decremented if the count on the first counter (CNT1) is lower than the reference value, and is incremented if the count on the first counter (CNT1) is not lower than the reference value.

2. Device according to Claim 1,
**characterized**
**in that** the device is set up such that it signals the failure of the clock signal (CLK) if the clock signal (CLK) has failed or has an excessively low frequency.

3. Device according to Claim 1,
**characterized**
**in that** the device is set up such that it signals the failure of the clock signal (CLK) if the clock signal (CLK) has an excessively high frequency.

4. Device according to one of the preceding claims,
**characterized**
**in that** the signals (BUSSIG) which are supplied to the chip containing the device are data which the relevant chip processes further.

5. Device according to one of the preceding claims,
**characterized**
**in that** the signals (BUSSIG) which are supplied to the chip containing the device are control signals which are required for transmitting data to the chip containing the device.

6. Device according to one of the preceding claims,
**characterized**
**in that** the at least one connecting line is a line for the interchange of data between the chips that are connected to one another by the at least one connecting line.

7. Device according to one of the preceding claims,
**characterized**
**in that** the at least one connecting line is a bus or part of a bus.

8. Device according to one of the preceding claims,
**characterized**
**in that** the particular events between which the counter (CNT1) counts the number of clock cycles of the clock signal (CLK) are rising or falling edges of the signals transmitted via the at least one connecting line.

9. Device according to one of the preceding claims,
**characterized**
**in that** the particular events between which the counter (CNT1) counts the number of clock cycles of the clock signal (CLK) are events which define a period of time having a particular length.

10. Device according to one of the preceding claims,
**characterized**
**in that** the device contains a comparator (CMP1), and in that the comparator (CMP1) is set up to check whether the count on the counter (CNT1) is above or below the reference value.

11. Device according to one of the preceding claims,
**characterized**
**in that** the device is set up such that the comparison result from the comparator (CMP1) governs whether the second counter (CNT2) counts upwards or downwards.

12. Device according to one of Claims 1 to 10,
**characterized**
**in that** the device is set up such that the value of a particular bit of the count on the first counter (CNT1) governs whether the second counter (CNT2) counts upwards or downwards.

13. Device according to one of the preceding claims,
**characterized**
**in that** the device contains a second comparator (CMP2), and in that the second comparator (CMP2) is set up to check whether the count on the second counter (CNT2) is above or below a second reference value.

14. Device according to Claim 13,
**characterized**
**in that** the output signal from the second comparator is used as an error signal (ERR) which signals whether or not there is a clock signal failure.

15. Device according to one of the preceding claims,
**characterized**
**in that** a particular bit of the count on the second counter (CNT2) is used as an error signal (ERR) which signals whether or not there is a clock signal failure.

16. Device according to Claim 10,
**characterized**
**in that** the output signal from the first comparator (CMP1) is used as an error signal (ERR) which signals whether or not there is a clock signal failure.

17. Device according to Claim 1,
**characterized**
**in that** a particular bit of the count on the first counter (CNT1) is used as an error signal (ERR) which signals whether or not the clock signal (CLK) has a proper profile.

## Revendications

1. Dispositif pour détecter une défaillance d'un signal d'horloge,
- le dispositif comportant un compteur (CNT1) qui est conçu de manière à compter le nombre des cycles d'horloge du signal d'horloge (CLK) se produisant entre deux événements déterminés, signal d'horloge dont la présence doit être vérifiée, et
- le dispositif étant conçu de manière à signaler l'apparition d'une erreur lorsque le compte du compteur (CNT1) s'abaisse une fois ou plusieurs fois en-dessous d'une valeur de référence déterminée, ou lorsque le compte du compteur (CNT1) s'élève une fois ou plusieurs fois au-dessus d'une valeur de référence déterminée,
**caractérisé**
- **en ce que** les événements déterminés entre lesquels le compteur (CNT1) compte le nombre de cycles du signal d'horloge (CLK) sont des événements qui se produisent sur une ou plusieurs lignes de connexion par l'intermédiaire desquelles le composant comportant le dispositif est connecté à un ou plusieurs autres composants, et par l'intermédiaire desquelles des signaux (BUSSIG) sont acheminés au composant comportant le dispositif depuis l'autre composant ou les autres composants,
- **en ce que** les événements déterminés entre lesquels le compteur (CNT1) compte le nombre de cycles du signal d'horloge (CLK) sont des événements synchrones dont l'apparition n'est soumise à aucune fluctuation ou qu'à de faibles fluctuations, et
- **en ce que** le dispositif comporte un second compteur (CNT2) qui est conçu de telle manière
- que son compte soit incrémenté lorsque le compte du premier compteur (CNTL) est inférieur à la valeur de référence, et soit décrémenté lorsque le compte du premier compteur (CNTL) n'est pas inférieur à la valeur de référence, ou qui est conçu de telle manière
- que son compte soit décrémenté lorsque le compte du premier compteur (CNT1) est inférieur à la valeur de référence, et soit incrémenté lorsque le compte du premier compteur (CNT1) n'est pas inférieur à la valeur de référence.

2. Dispositif selon la revendication 1, **caractérisé en ce que** le dispositif est conçu de manière à signaler la défaillance du signal d'horloge (CLK) lorsque le signal d'horloge (CLK) est défectueux ou lorsqu'il présente une trop faible fréquence.

3. Dispositif selon la revendication 1, **caractérisé en ce que** le dispositif est conçu de manière à signaler la défaillance du signal d'horloge (CLK) lorsque le signal d'horloge (CLK) présente une fréquence trop élevée.

4. Dispositif selon l'une quelconque des revendications précédentes, **caractérisé en ce que** les signaux (BUSSIG) qui sont acheminés au composant comportant le dispositif sont des données qui sont soumises à un traitement ultérieur dans le composant concerné.

5. Dispositif selon l'une quelconque des revendications précédentes, **caractérisé en ce que** les signaux (BUSSIG) qui sont acheminés au composant comportant le dispositif sont des signaux de commande qui sont nécessaires pour la transmission de données au composant comportant le dispositif.

6. Dispositif selon l'une quelconque des revendications précédentes, **caractérisé en ce que** l'au moins une ligne de connexion est une ligne destinée à l'échange de données entre les composants connectés les uns aux autres par l'intermédiaire de l'au moins une ligne de connexion.

7. Dispositif selon l'une quelconque des revendications précédentes, **caractérisé en ce que** l'au moins une liaison de connexion est un bus ou une partie d'un bus.

8. Dispositif selon l'une quelconque des revendications précédentes, **caractérisé en ce que** les événements déterminés entre lesquels le compteur (CNT1) compte le nombre de cycles du signal d'horloge (CLK) sont des fronts montants ou descendants des signaux transmis par l'intermédiaire de l'au moins une ligne de connexion.

9. Dispositif selon l'une quelconque des revendications précédentes, **caractérisé en ce que** les événements déterminés entre lesquels le compteur (CNT1) compte le nombre de cycles du signal d'horloge (CLK) sont des événements définissant un intervalle de temps de longueur déterminée.

10. Dispositif selon l'une quelconque des revendications précédentes, **caractérisé en ce que** le dispositif comporte un comparateur (CMP1) et **en ce que** le comparateur (CMP1) est conçu de manière à vérifier si le compte du compteur (CNT1) s'élève au-dessus ou s'abaisse en dessous de la valeur de référence.

11. Dispositif selon l'une quelconque des revendications précédentes, **caractérisé en ce que** le dispositif est conçu de telle manière que le second compteur (CNT2) compte en sens progressif ou en sens dégressif en fonction du résultat de comparaison du comparateur (CMP1).

12. Dispositif selon l'une quelconque des revendications 1 à 10, **caractérisé en ce que** le dispositif est conçu de telle manière que le second compteur (CNT2) compte en sens progressif ou en sens dégressif en fonction de la valeur d'un bit déterminé du compte du premier compteur (CNT1) .

13. Dispositif selon l'une quelconque des revendications précédentes, **caractérisé en ce que** le dispositif comporte un second comparateur (CMP2) et **en ce que** le second comparateur (CMP2) est conçu de manière à vérifier si le compte du second compteur (CNT2) s'élève au-dessus ou s'abaisse en dessous d'une seconde valeur de référence.

14. Dispositif selon la revendication 13, **caractérisé en ce que** le signal de sortie du second comparateur est utilisé en tant que signal d'erreur (ERR) au moyen duquel il est signalé si une défaillance du signal d'horloge est ou non présente.

15. Dispositif selon l'une quelconque des revendications précédentes, **caractérisé en ce qu'**un bit déterminé du compte du second compteur (CNT2) est utilisé en tant que signal d'erreur (ERR) au moyen duquel il est signalé si une défaillance du signal d'horloge est ou non présente.

16. Dispositif selon la revendication 10, **caractérisé en ce que** le signal de sortie du premier comparateur (CMP1) est utilisé en tant que signal d'erreur (ERR) au moyen duquel il est signalé si une défaillance du signal d'horloge est ou non présente.

17. Dispositif selon la revendication 1, **caractérisé en ce qu'**un bit déterminé du compte du premier compteur (CNT1) est utilisé en tant que signal d'erreur (ERR) au moyen duquel il est signalé si le signal d'horloge (CLK) présente ou non une évolution régulière.
